# EUROPÄISCHE PATENTSCHRIFT

(11) **EP 1 674 962 B1**
(45) Veröffentlichungstag und Bekanntmachung des Hinweises auf die Patenterteilung: **02.09.2009**
(21) Anmeldenummer: 04405799.0
(22) Anmeldetag: 22.12.2004
(51) Int. Cl.: G06F 1/00, H05K 5/02

(54) **Vorrichtung zum Schutz von in einer aus elektronischen Bauelementen und einem Prozessor bestehenden Schaltanordnung gespeicherten Daten**
Device for protecting a data storage circuit arrangement comprising electronic components and a processor
Dispositif de protection des informations enregistrées dans un circuit comprenant des composants électroniques et un processeur.

(43) Veröffentlichungstag der Anmeldung: 28.06.2006
(73) Patentinhaber: FRAMA AG, 3438 Lauperswil (CH)
(72) Erfinder: Haug, Thomas, 3550 Langnau im Emmental (CH)
(74) Vertreter: Fenner, Werner

(56) Entgegenhaltungen:
- EP-A- 1 054 316
- EP-A- 1 273 997
- WO-A-01/63994
- GB-A- 2 275 914
- US-A- 5 027 397
- US-A- 5 353 350
- US-A1- 2002 002 683

## Beschreibung

Die Erfindung betrifft eine Vorrichtung zum Schutz von in einer aus elektronischen Bauelementen und einem Prozessor bestehenden Schaltanordnung gespeicherten Daten zum Betreiben bzw. Steuern von Funktionen eines Betriebssystems, Verfahrens, Gerätes und/oder einer Maschine, umfassend ein aus zwei Gehäuseteilen gebildetes Gehäuse, einen Messwertgeber oder Sensor, der aus einer an einem flexiblen Trägermaterial befestigten Leiterbahn besteht.

Nicht nur das Internet, auch ganz allgemein der Umgang mit elektronischen Daten und Informationen verlangen in jeder Organisation, die einen wichtigen Teil eines Geschäftsgeheimnisses einnehmen, eine sichere Speicherung und Uebertragung von Daten.
Hierbei stützen sich verschiedene Strategien zur Ristkoverwaltung u.a. auf den Einsatz kryptographischer Verfahren, um den Schutz, die Sicherheit und die Verfügbarkeit von Daten zur Steuerung von Betriebssystemen, Geräten und/oder Maschinen gewährleisten und in schneller Reihenfolge entscheidende technische, geschäftliche oder rechtliche Ergebnisse abrufen oder einleiten zu können.

In der Vergangenheit haben Anwendungsentwickler kaum Sicherheitsfunktionen in ihre Produkte eingebaut, weil die entsprechende Nachfrage fehlte und ein Einbau von Sicherheitsfunktionen den Preis der Produkte spürbar angehoben hätte.

Ein wichtiges Sicherheitsorgan ist die Kryptographie, die von Ingenieuren in neuentwickelte Produkte eingebaut wird und die die Produkte hinsichtlich Anwendung und Missbrauch zuverlässig sichern. Kryptographische Verfahren resp. Verschlüsselungen durch Zeichen und Zahlen resp. definierte Algorythmen werden auch in Datenbanken eingesetzt, die den Schutz und Verkehr vertraulicher Informationen regeln.
Auch persönliche Daten wollen geschützt sein, nicht zuletzt zum Selbstschutz.

Um Geheimnisse vor unberechtigten resp. missbräuchlichen Zugriffen zu sichern, werden in Betriebssystemen von Rechnern mehrfach wirkende Schutzmassnahmen eingeführt.
Ein Angriff auf verschlüsselte Daten erfolgt oft durch einen Entschlüsselungsvorgang, indem der Angreifer beispielsweise den Schlüssel zu ermitteln oder den Algorythmus zu brechen versucht. Gelingt ein Angriff, dann kann der Angreifer die kompromittierten und weiterhin gültigen Schlüssel verwenden und unerkannt grossen Schaden anrichten.

Gegen ein solches Vorgehen ist u.a. ein elektromechanisches Schloss an einem Gehäuse bekannt, welches bewirkt, dass beim Oeffnen des Gehäuses das Betriebssystem einer Einrichtung oder wenigstens sicherheitsrelevante Daten elektronischer Bauelemente einer Schaltanordnung sofort gelöscht werden. Das Schloss besteht beispielsweise aus einem einerseits an einer Platine, Printplatte oder dgl. befestigten, andererseits mit dem Gehäuse verbundenen elektromechanischen Schalter.
Dieses Sicherheits-Prinzip eignet sich jedoch nicht, wenn ein Angriff auf die Betriebsdaten ohne ein Oeffnen eines aus mehreren Gehäuseteilen bestehenden Gehäuses beabsichtigt ist, beispielsweise durch Bohren einer Zugangsöffnung in das Gehäuse.
Es sind somit zum Schutz von elektronisch, gespeicherten Betriebsdaten weiterreichende Sicherheitsvorkehrungen gefragt.

Bisher wurden Schutzsensoren aussen um ein Gehäuse gewickelt. Dies ist mit dem Nachteil behaftet, dass die Sensoren Anschlüsse aufweisen, die von innen nach aussen geführt sind und so hochfrequente Signale transportieren. Es sind Filtermassnahmen notwendig, welche das Sicherheitsrisiko jedoch nicht ganz ausschliessen können.

Die WO 99/48055 beschreibt u.a. eine "Tamper resistant postal security device" mit einem, elektronische Bauelemente aufweisenden Datenträger zur Speicherung und Generierung von Druckdaten für gedruckte Postwertzeichen schützenden Gehäuse.

Die vorveröffentlichte GB 2'275'914 A offenbart eine auf einen Angriff reagierende Vorrichtung, die ein zur Aufnahme geschützter Daten ausgebildetes, ummanteltes Modul aufweist. Der Zugang zu dem Modul erfolgt über ein Memory. Der Inhalt der Vorrichtung dient dem Detektieren eines versuchten Angriffs auf das Datenvorkommen, wozu ein eingeschlossener Monitor vorgesehen ist, der bei Feststellung eines Angriffs einen Löschkreis aktiviert, um die im Modul und dem Memory enthaltenen Daten rechtzeitig zu löschen. Die Wände der die elektronische Schaltanordnung umfassenden Vorrichtung bestehen aus drei wesentlichen Komponenten: nämlich, einer Hülle, vorzugsweise aus Metall; einer inneren Umhüllung in Form einer auf einen Angriff reagierenden gefalteten Schicht; und einer äusseren Hülle in Form eines Giessharzes.

Die ältere US 2002/0002683 A1 betrifft eine Einrichtung zum Schutz elektronischer Komponenten oder Daten, vorzugsweise eine Anordnung für ein Sicherheitsmodul, das elektronische Komponenten enthält und gegen unerlaubten Zugang zu den elektronischen Komponenten Schutz bietet. Eine Ausführung zum Schutz elektronischer Komponenten mit einer Befestigungsplatte aus X-ray Material für die aufgebauten Komponenten und eine aufsetzbare Platte, an deren Unterseite eine Randdichtung befestigt ist, bilden einen Hohlraum zur Unterbringung der elektronischen Komponenten. Die Aussenhaut an der Platte dient als Abwehrmittel gegen Röntgenstrahlen und andere elektromagnetische Werkzeuge, mit denen versucht werden könnte, in das Sicherheitsmodul einzudringen.

Die US 5'353'350 A vermittelt eine auf einen Angriff resistente Vorrichtung. In einem einteiligen Gehäuse ist ein von einem polymeren Werkstoff ummantelter resp. eingeschlossener elektrischer Schaltkreis oder eine elektronische Vorrichtung vor einem Angriff auf oder Diebstahl von Daten geschützt. Der elektroaktive Polymermantel ist mit dem eingeschlossenen Prozesskreis durch Bandkabel verbunden.

Die EP 1'273'997 A2 beschreibt ein zugriffssicheres Modul zum Schutz elektronischer Komponenten. Das Modul besteht aus einer elektronischen Komponente oder einem Schaltkreis, einem auf einen Angriff resistenten Blatt und ummantelndem Epoxiharz, so dass die elektronische Komponente von dem giessfähigen Material umschlossen ist und die Blätter jeweils an der elektronischen Komponente anlegen.

Es stellt sich die Aufgabe an die vorliegende Erfindung, eine Vorrichtung der eingangs genannten Art zu schaffen, mit der ein Angriff auf gespeicherte Betriebsdaten über ein schützendes Gehäuse verhindert werden kann.

Erfindungsgemäss wird die Aufgabe dadurch gelöst, dass die Leiterbahn (8) aus einer Vielzahl in wenigstens einer Ebene nebeneinander verlaufenden, leitend verbundenen Bahnabschnitten (11) gebildet ist wobei die Schaltanordnung (7) innerhalb des Gehäuses (3) an einer Platine (4) befestigt ist, wobei der Messwertgeber oder Sensor entlang der Innenwände der Gehäuseteile (2, 5) durch Kleben befestigt ist und wobei die Schaltanordnung (7) mittels am flexiblen Trägermaterial geformten Kontaktfahnen (9, 10) mit dem Messwertgeber oder Sensor verbunden ist.

Dadurch sind die elektronischen Bauelemente resp. die Schaltanordnung auf der Platine von einem Schutzmantel vollständig umgeben resp. nach aussen abgeschirmt und geschützt, sodass bei einer versuchten Veränderung des Gehäuses, beispielsweise durch Unbefugte, auf eine innerhalb des Gehäuses in einer elektronischen Schaltanordnung gespeicherte Daten ein erfolgreicher Zugriff ausgeschlossen werden kann.
Messwertgeber oder Sensoren erzeugen elektrische Signale in der Steuerungstechnik, der Ueberwachung und Sicherung von Anlagen und Systemen, wo Abweichungen vorgegebener Sollgrössen festzustellen und in Steuer- und/oder RegelSignale umzuwandeln sind. Messwertgeber und Sensoren sind Elemente, deren Eigenschaften durch elektrische Grössen, z.B. einen elektrischen Strom, oder durch nichtelektrische Grössen, beispielsweise eine Kraft, beeinflusst werden. Sie formen u.a. elektrische, mechanische, thermische, optische und chemische Grössen in passende elektrische Signale um.
Weiterhin sollen mit der vorgeschlagenen Vorrichtung gespeicherte Daten sowohl gelöscht werden können als auch alternativ ein Löschen initiiert werden können.

Vorteilhaft ist die vorzugsweise biegsame Leiterbahn zwischen der Schaltanordnung und einer elektrischen Stromquelle angeordnet, beispielsweise einer Batterie oder einem Transformer, sodass bei einem Stromunterbruch die in der Schaltanordnung elektronisch gespeicherten Daten oder zumindest ein Teil davon gelöscht oder eine Löschung iniziiert werden.

Die Leiterbahn kann vorzugsweise aus einer Vielzahl in wenigstens einer Ebene verteilt nebeneinander und/oder übereinander verlaufenden, zusammenhängenden Bahnabschnitten gebildet sein, wobei die Abstände der Bahnabschnitte zueinander minimal gehalten sind, sodass ein dünnes Bohrwerkzeug ausreicht, einen Unterbruch der Leiterbahn zu bewirken resp. gespeicherte Daten zu löschen.
Zur Befestigung der Leiterbahn eignet sich ein mit dieser verbundenes Trägermaterial, das an den Gehäuseinnenwänden anbringbar resp. mit diesen flächendeckend verbindbar ist, wobei das Gehäuse mehrteilig und/oder geschlossen ausgebildet sein kann.
Bei einem Vergiessen der Schaltanordnung könnte eine dazu verwendbare Form als Trägermaterial der Leiterbahn benutzt werden, wobei die Form einen Schutzmantel der Leiterbahn bilden könnte.

Als einfach erweist sich ein starres, flexibles resp. biegsames Trägermaterial, welches sich mit den Gehäuseinnenwänden kompakt verbinden lässt und auch die Uebergänge der Innenwände abdeckt.

Das Trägermaterial kann beispielsweise eine Folie sein, die an den Gehäuseinnenwänden, beispielsweise mittels Klebstoff befestigt wird. Die Leiterbahn resp. Folie kann mehrteilig sein und lässt sich an den Innenwänden einfach aus- und anlegen.

Dabei kann die Leiterbahn auf eine Folie gedruckt oder gespritzt und danach mit einer Schutzschicht abgedeckt werden.

Zweckmässig ist die Leiterbahn innerhalb einem zur Folie verarbeitbaren Kunststoff, beispielsweise Kunstharz angeordnet, wodurch mehrere Möglichkeiten zur Anbringung und Ausgestaltung der Leiterbahn an den Gehäuseinnenwänden entstehen.

Hierbei kann die Leiterbahn nach der Oberfläche der Innenwände des Gehäuses konfektioniert sein und danach an den Innenwänden aufgeklebt bzw. mit diesen ganzflächig verbunden werden.

Oder die Leiterbahn kann zwischen gespritzten oder sonstwie aufgetragenen Schichten aus Kunststoff eingelegt sein, wobei zwischen Gehäuseinnenwand und der Leiterbahn eine an den Gehäuseinnenwänden haftende Schutz- oder Isolationsschicht aufgetragen wird. Selbstverständlich kann ein anderer Schichtaufbau an der Gehäuseinnenwand vorgenommen werden, der den Anforderungen an eine isolierende Befestigung entspricht.

Zweckmässig besteht das Gehäuse aus einem ferromagnetischen Werkstoff, der ein Wirken magnetischer oder elektrischer Felder von aussen auf die elektronischen Bauelemente oder von den Bauelementen nach aussen erheblich einschränkt.

Vorteilhaft sind die Leiterbahn und die Bauelemente der Schaltanordnung -auch mit der elektrischen Stromquelle- in Serie oder parallel geschaltet.

Zur Verbindung der Leiterbahn mit den elektronischen Bauelementen und dem Prozessor der Schaltanordnung sind vorzugsweise an der Platine befestigte Kontakte vorgesehen.

Sollte der Angriff auf Betriebsdaten der Schaltanordnug dem Verschluss eines mehrteiligen Gehäuses gelten, wobei die Platine mit der Schaltanordnung an einem Gehäuseteil befestigt ist, ist an der Platine ein mechanischer oder elektromechanischer Schalter befestigt, der durch ein an dem anderen Gehäuseteil befestigtes Schaltorgan betätigbar ist.

Vorrichtungen der vorgeschlagenen Art eignen sich zum Datenschutz besonders bei Geld- und postalischen Wertzeichenautomaten, Frankiermaschinen, Betriebssystemen, Systemen für den elektronischen Datentransfer etc.

Alternativ kann im Sinne der vorgeschlagenen Vorrichtung auch die die Bauelemente aufnehmende Platine resp. die Leiterplatte als Messwertgeber oder Sensor ausgebildet sein.

Dabei kann die Platine eine Leiterbahn im Sinne der empfohlenen technischen Merkmale aufweisen, wobei die Platine flexibel, beispielsweise als Folie ausgebildet sein kann.
Anschliessend wird die erfindungsgemässe Vorrichtung unter Bezugnahme auf die Zeichnung, auf die bezüglich aller in der Beschreibung nicht erwähnten Einzelheiten verwiesen wird, anhand eines Ausführungsbeispiels erläutert. In der Zeichnung zeigen:
- Fig. 1: einen Querschnitt einer erfindungsgemässen Vorrichtung,
- Fig. 2: eine von einer Folie geschützte, konfektionierte Leiterbahn und
- Fig. 3: einen Gehäuseteil eines mehrteiligen Gehäuses der Vorrichtung in räumlicher Darstellung.

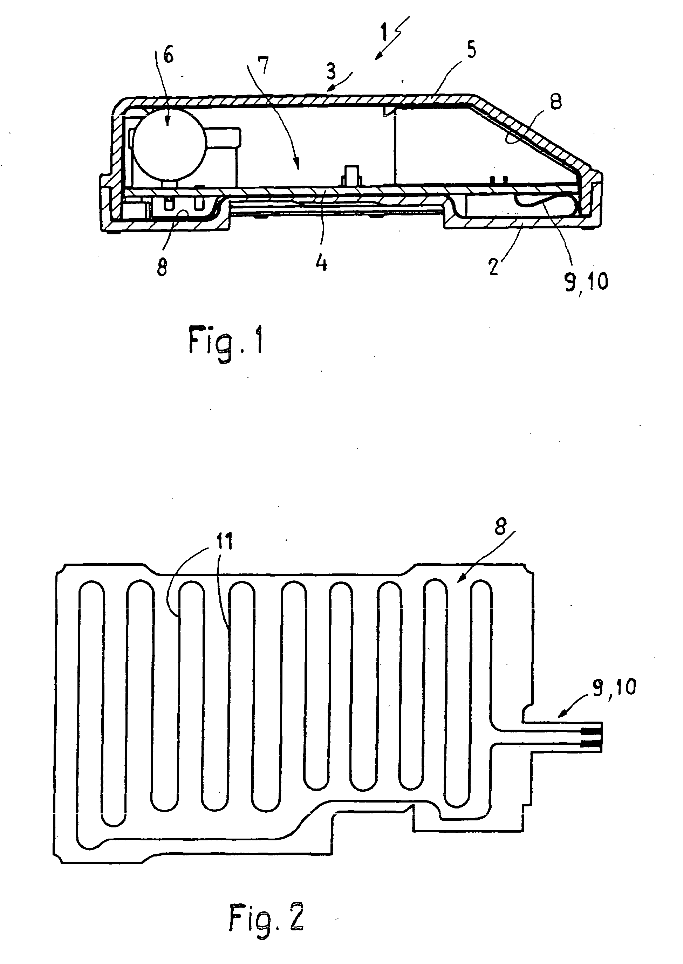

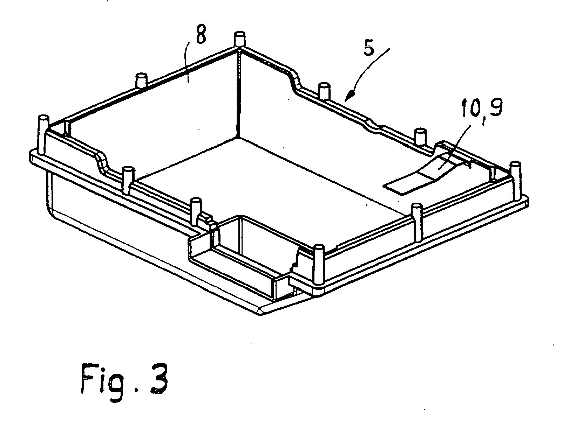

Fig. 1 zeigt eine Vorrichtung 1 zum Schutz von in einer aus elektronischen Bauelementen 6 und wenigstens einem Prozessor resp. Mikrokontroller bestehenden Schaltanordnung 7 (teilweise ersichtlich) gespeicherten Daten resp. Betriebsdaten zum Betreiben bzw. Steuern von Funktionen eines Betriebssystems, Verfahrens, Gerätes und/oder einer Maschine.
Diese Vorrichtung 1 weist ein Gehäuseteil 2 eines geschlossenen Gehäuses 3 auf, an dem eine Platine 4 der elektronischen Schaltanordnung 7 lösbar befestigt ist. Die Innenwände des Gehäuses 3 resp. der Gehäuseteile 2 und 5, letzterer ist vorliegend als Abdeckung in dem Gehäuseteil 2 lösbar gehaltenen Schaltanordnung 7 vorgesehen, sind mit einer mit der Schaltanordnung 7 leitend verbundenen Leiterbahn 8 beschlagen.
Die Leiterbahn 8 ist mit der aus elektronischen Bauelementen 6 und einem Prozessor gebildeten Schaltanordnung 7 und einer Energiequelle resp. elektrischen Stromquelle niedriger Spannung verbunden, beispielweise einer Batterie. Gemäss dargestelltem Ausführungsbeispiel sind die Innenwände der voneinander trennbaren Gehäuseteile 2, 5 mit jeweils einer folienartigen Leiterbahn 8 ausgestattet, die mit den Bauelementen 6 der Schaltanordnung 7 leitungsverbunden sind. Die Verbindung erfolgt gemäss den Fig. 1 und 3 mittels Kontaktfahnen 9, 10, die einen mit der Leiterbahn 8 verbundenen Leitungsabschnitt aufweisen, der über einen Kontakt (nicht sichtbar) die Schaltanordnung 7 mit der Leiterbahn 8 verbindet.
Die Leiterbahn 8 besteht beispielsweise aus einer Vielzahl in mehrere Ebenen verlegbaren, nebeneinander verlaufender,leitend zusammenhängender Bahnabschnitte 11, wie in Fig. 2 ausgestreckt gezeigt. Diese leitend verbundenen Bahnabschnitte 11 verlaufen in geringen Abständen flächedeckend nebeneinander oder wenigstens teilweise übereinander, sodass ein Durchbrechen des Gehäuses 3 zu einer einen Unterbruch der Leiterbahn 8 bewirkenden Verletzung führt.
Die in Fig. 2 dargestellte Leiterbahn 8 ist nach der Oberfläche der Innenwände des Gehäuses 3 konfektioniert und lässt sich aufgrund einer flexiblen resp. biegsamen Ausgestaltung lückenlos an den Innenwänden verlegen. Selbstverständlich könnten auch einzelne, untereinander elektrisch verbundene Elemente der Leiterbahn 8 an den Innenwänden des Gehäuses 3 resp. den Gehäuseteilen 2, 5 befestigt werden. Solche Elemente könnten sich zur Meidung von Lücken an den Rändern überlappen.
Die Verlegung bzw. Befestigung der Leiterbahn 8, resp. Elemente davon könnten durch Kleben, Schweissen oder Vergiessen vorgenommen werden.
Bei einer alternativen Ausführungsform zur Auslegung und Befestigung der Leiterbahn/en an den Innenwänden des Gehäuses 3 werden Schichten aufgetragen, zwischen denen die Leiterbahn/en angeordnet sind, beispielsweise durch Spritzen oder Giessen, wobei eine erste Schicht auf die Innenwand der Isolation der Leiterbahn 8 gegenüber dem metallischen Gehäuse 3 und als Trägermaterial der Leiterbahn 8 dient, und darüber eine Schutzschicht aufgetragen wird. Selbstverständlich kann bei der Herstellung und Anordnung der Leiterbahn ein anderer Schichtaufbau angewandt werden.
Der Werkstoff für das Gehäuse 3 kann zum Schutz gegen magnetische und/oder elektrische Felder elektrisch leitfähig, beispielsweise ein ferromagnetischer Werkstoff sein.
Die Verbindung der Leiterbahn 8 mit der Schaltanordnung 7 über eine Kontaktfahne 9, 10 erfolgt mittels Kontakt an der Schaltanordnung 7 resp. der Platine 4.
Im Sinne eines umfassenden Schutzes der Schaltanordnung 7, die in einem Gehäuse 3 aus einem zur Befestigung der Platine 4 der Schaltanordnung 7 ausgebildeten Gehäuseteil 2 und einem die elektronischen Bauteile 6 abdeckenden Gehäuseteil 5 gebildet ist, ist an der Platine 4 ein elektromechanisch betätigbarer und mit der Schaltanordnung 7 elektrisch verbundener Schalter (nicht dargestellt) vorhanden, der über ein an einem Gehäuseteil 2, 5 befestigten Schaltorgan 12 betätigt wird.
Beim Ausführungsbeispiel ist das Schaltorgan 12 gemäss Fig. 1 an dem die Platine 4 haltenden Gehäuseteil 2 angeordnet.
Der gemäss Fig. 1 und 3 haubenartig ausgebildete Gehäuseteil 5 wird über die mit elektronischen Bauelementen 6 und einem Prozessor versehene Platine 4 resp. Schaltanordnung 7 gesetzt und mit dem Gehäuseteil 2 zu einem allseitig geschlossenen Gehäuse 3 formschlüssig resp. fest verbunden.
Bei dem Gehäuse 3 oder den Gehäuseteilen 2, 5 handelt es sich vorwiegend um Spritz- oder Giesslinge, vorzugsweise aus Metall.
Das Gehäuse 3 weist einen Zugang resp. eine Oeffnung auf durch welche die Schaltanordnung 7 mit einer externen Datenstelle verbindbar ist.

## Patentansprüche

1. Vorrichtung (1) zum Schutz von in einer aus elektronischen Bauelementen (6) und einem Prozessor bestehenden Schaltanordnung (7) gespeicherten Daten zum Betreiben bzw. Steuern von Funktionen eines Betriebssystems, Verfahrens, Gerätes und/oder einer Maschine, umfassend ein aus zwei Gehäuseteilen (2, 5) gebildetes Gehäuse (3), einen Messwertgeber oder Sensor, der aus einer an einem flexiblen Trägermaterial befestigten Leiterbahn (8) besteht, wobei die Leiterbahn (8) aus einer Vielzahl in wenigstens einer Ebene nebeneinander verlaufenden, leitend verbundenen Bahnabschnitten (11) gebildet ist, wobei die Schaltanordnung (7) innerhalb des Gehäuses (3) an einer Platine (4) befestigt ist, wobei der Messwertgeber oder Sensor entlang der Innenwände der Gehäuseteile (2, 5) durch Kleben befestigt ist und wobei die Schaltanordnung (7) mittels am flexiblen Trägermaterial geformten Kontaktfahnen (9, 10) mit dem Messwertgeber oder Sensor verbunden ist.

2. Vorrichtung nach Anspruch 1, **dadurch gekennzeichnet, dass** die Leiterbahn (8) zwischen der Schaltanordnung (7) der Bauelemente (6) und einer elektrischen Stromquelle angeordnet ist.

3. Vorrichtung nach Anspruch 1 oder 2, **dadurch gekennzeichnet, dass** das Trägermaterial folienartig ausgebildet ist.

4. Vorrichtung nach einem der Ansprüche 1 bis 3, **dadurch gekennzeichnet, dass** die Leiterbahn (8) auf eine Folienbahn gedruckt oder gespritzt und mit einer Schutzschicht abgedeckt ist.

5. Vorrichtung nach einem der Ansprüche 1 bis 4, **dadurch gekennzeichnet, dass** die Leiterbahn (8) innerhalb einem zur Folie verarbeiteten Kunststoff angeordnet ist.

6. Vorrichtung nach einem der Ansprüche 1 bis 5, mit einem aus wenigstens zwei Gehäuseteilen (2, 5) gebildeten geschlossenen Gehäuse (3), **dadurch gekennzeichnet, dass** die Leiterbahn (8) nach der Oberfläche der Innenwände des Gehäuses (3) oder der Gehäuseteile (2, 5) konfektioniert ist.

7. Vorrichtung nach einem der Ansprüche 1 bis 6, **dadurch gekennzeichnet, dass** die Anordnung der Leiterbahn (8) durch Auftragen von Schichten an den Innenwänden des Gehäuses (3) erfolgt.

8. Vorrichtung nach einem der Ansprüche 1 bis 7, **dadurch gekennzeichnet, dass** das Gehäuse (3) aus einem elektrisch leitfähigen, beispielsweise wenigstens teilweise ferromagnetischen Werkstoff gebildet ist.

9. Vorrichtung nach einem der Ansprüche 1 bis 8, **dadurch gekennzeichnet, dass** die Bauelemente (6) der Schaltanordnung (7) und die Leiterbahn in Serie oder parallel geschaltet sind.

10. Vorrichtung nach einem der Ansprüche **1** bis **9,** mit einem Gehäuse (3) aus einem zur Befestigung der Platine (4) der Schaltanordnung (7) ausgebildeten Gehäuseteil (2, 5) und einem weiteren Gehäuseteil (5, 2), **dadurch gekennzeichnet, dass** an der Platine (4) ein mechanisch oder elektromechanisch betätigbarer Schalter und an dem weiteren Gehäuseteil (5, 2) ein Schaltorgan (12) befestigt sind.

11. Vorrichtung nach einem der Ansprüche 1 bis 10, **dadurch gekennzeichnet, dass** die Platine (4) als Messwertgeber oder Sensor ausgebildet ist.

12. Vorrichtung nach Anspruch 11, **dadurch gekennzeichnet, dass** die Platine (4) eine Leiterbahn (8) aufweist.

## Claims

1. Device (1) for protecting data for operating or controlling functions of an operating system, processes, equipment and/or a machine stored in a circuit arrangement (7) consisting of electronic components (6) and a processor, comprising a housing (3) formed of two housing parts (2, 5), and a transducer or sensor consisting of a conductor track (8) mounted on a flexible base material, the conductor track (8) being formed of a plurality of conductively connected track sections (11) extending alongside one anther in at least one plane, the circuit arrangement (7) being mounted on a printed circuit board (4) within the housing (3), the transducer or sensor being mounted along the inner walls of the housing parts (2, 5) by bonding and the circuit arrangement (7) being connected to the transducer or sensor by means of tabs (9, 10) formed on the flexible base material.

2. Device according to claim 1, **characterised in that** the conductor track (8) is arranged between the circuit arrangement (7) of the components (6) and an electric power source.

3. Device according to claim 1 or claim 2, **characterised in that** the base material is in the form of a foil.

4. Device according to one of claims 1 to 3, **characterised in that** the conductor track (8) is printed or injected on to a foil sheet and covered with a protective layer.

5. Device according to one of claims 1 to 4, **characterised in that** the conductor track (8) is arranged within a plastic processed into the foil.

6. Device according to one of claims 1 to 5, comprising a closed housing (3) formed of at least two housing parts (2, 5), **characterised in that** the conductor track (8) is adapted to the surface of the inner walls of the housing (3) or of the housing parts (2, 5).

7. Device according to one of claims 1 to 6, **characterised in that** the conductor track (8) is designed by applying layers to the inner walls of the housing (3).

8. Device according to one of claims 1 to 7, **characterised in that** the housing (3) is formed of an electrically conductive, e.g. at least partly ferromagnetic material.

9. Device according to one of claims 1 to 8, **characterised in that** the components (6) of the circuit arrangement (7) and the conductor track are connected in series or in parallel.

10. Device according to one of claims 1 to 9, comprising a housing (3) consisting of one housing part (2, 5) designed for the mounting of the printed circuit board (4) of the circuit arrangement (7) and another housing part (5, 2), **characterised in that** a mechanically or electromechanically actuated switch is mounted on the printed circuit board (4) and a switching element (12) is mounted on the other housing part (5, 2).

11. Device according to one of claims 1 to 10, **characterised in that** the printed circuit board (4) is designed as a transducer or sensor.

12. Device according to claim 11, **characterised in that** the printed circuit board (4) comprises a conductor track (8).

## Revendications

1. Dispositif (1) de protection de données qui sont enregistrées dans un circuit (7) comprenant des composants électroniques (6) et un processeur et qui servent à faire fonctionner et/ou commander des fonctions d'un système d'exploitation, d'un procédé, d'un appareil et/ou d'une machine, comprenant un boîtier (3) formé de deux parties de boîtier (2, 5), un transmetteur de valeurs de mesure ou capteur qui est composé d'une piste conductrice (8) fixée sur un matériau de support flexible, la piste conductrice (8) étant formée d'une pluralité de portions de piste (11) s'étendant les unes à côté des autres dans au moins un plan et reliées de manière conductrice, le circuit (7) étant fixé sur une platine (4) à l'intérieur du boîtier (3), le transmetteur de valeurs de mesure ou capteur étant fixé par collage le long des parois intérieures des parties de boîtier (2, 5) et le circuit (7) étant relié au transmetteur de valeurs de mesure ou capteur par l'intermédiaire de talons de contact (9, 10) formés sur le matériau de support flexible.

2. Dispositif selon la revendication 1, **caractérisé en ce que** la piste conductrice (8) est disposée entre le circuit (7) des composants (6) et une source de courant électrique.

3. Dispositif selon la revendication 1 ou 2, **caractérisé en ce que** le matériau de support est réalisé à la manière d'une feuille.

4. Dispositif selon l'une des revendications 1 à 3, **caractérisé en ce que** la piste conductrice (8) est imprimée ou projetée sur une bande de feuille et recouverte d'une couche de protection.

5. Dispositif selon l'une des revendications 1 à 4, **caractérisé en ce que** la piste conductrice (8) est disposée à l'intérieur d'une matière plastique transformée en feuille.

6. Dispositif selon l'une des revendications 1 à 5, avec un boîtier fermé (3) formé par au moins deux parties de boîtier (2, 5), **caractérisé en ce que** la piste conductrice (8) est confectionnée après la surface des parois intérieures du boîtier (3) ou des parties de boîtier (2, 5).

7. Dispositif selon l'une des revendications 1 à 6, **caractérisé en ce que** la disposition de la piste conductrice (8) est réalisée par application de couches sur les parois intérieures du boîtier (3).

8. Dispositif selon l'une des revendications 1 à 7, **caractérisé en ce que** le boîtier (3) est formé d'un matériau électroconducteur, par exemple au moins partiellement ferromagnétique.

9. Dispositif selon l'une des revendications 1 à 8, **caractérisé en ce que** les composants (6) du circuit (7) et la piste conductrice sont connectés en série ou en parallèle.

10. Dispositif selon l'une des revendications 1 à 9, avec un boîtier (3) composé d'une partie de boîtier (2, 5) réalisée de sorte à fixer la platine (4) du circuit (7) et d'une autre partie de boîtier (5, 2), **caractérisé en ce qu'**un commutateur à commande mécanique ou électromécanique est fixé sur la platine (4) et un organe de commutation (12) sur l'autre partie de boîtier (5, 2).

11. Dispositif selon l'une des revendications 1 à 10, **caractérisé en ce que** la platine (4) est réalisée en tant que transmetteur de valeurs de mesure ou capteur.

12. Dispositif selon la revendication 11, **caractérisé en ce que** la platine (4) présente une piste conductrice (8).
